Europäisches Patentamt

European Patent Office

Office européen des brevets

(19)

(11) Veröffentlichungsnummer: **0 027 553**
**B1**

(12) **EUROPÄISCHE PATENTSCHRIFT**

(45) Veröffentlichungstag der Patentschrift:
25.05.83

(51) Int. Cl.³: **C 23 C 11/06, H 01 L 31/18**

(21) Anmeldenummer: **80105638.3**

(22) Anmeldetag: **19.09.80**

(54) **Verfahren zur Herstellung von Halbleiterbauelementen aus amorphem Silizium zur Umwandlung von Licht in elektrische Energie und Einrichtung zur Durchführung des Verfahrens.**

(30) Priorität: **13.10.79 DE 2941559**

(43) Veröffentlichungstag der Anmeldung:
**29.04.81 Patentblatt 81/17**

(45) Bekanntmachung des Hinweises auf die Patenterteilung:
**25.05.83 Patentblatt 83/21**

(84) Benannte Vertragsstaaten:
**FR GB IT**

(73) Patentinhaber: **Messerschmitt-Bölkow-Blohm Gesellschaft mit beschränkter Haftung, Postfach 801109, D-8000 München 80 (DE)**

(72) Erfinder: **Königer, Max, Dr. Phys., Wolfratshauser Strasse 88, D-8023 Pullach (DE)**
Erfinder: **Winterling, Gerhard, Dr. Phys., Hermann Lönsstrasse 16, D-8012 Ottobrunn (DE)**

(56) Entgegenhaltungen:
**EP-A-0 002 383**
**US-A-3 655 438**
**IBM TECHNICAL DISCLOSURE BULLETIN, Band 21, Nr. 9, Februar 1979, Seite 3760 New York, USA M. CHEN et al.: »Use of a magnetic field to adjust the stoichiometry of plasma-deposited thin films«**
**EXTENDED ABSTRACTS, Band 77, Nr. 2, Oktober 1977, Seiten 423—425 T. TSUCHIMOTO: »Plasma deposition & etching characteristics by plasma stream transport method«**
**THIN SOLID FILMS, Band 54, Nr. 1, Oktober 1978, Seiten 33—47 S. SCHILLER et al.: »The role of plasmatron/magnetron systems in physical vapor deposition techniques«**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren zur Herstellung von Halbleiterbauelementen aus amorphem Silizium zur Umwandlung von Licht in elektrische Energie und Einrichtung zur Durchführung des Verfahrens

Die Erfindung betrifft ein Verfahren zur Herstellung von Halbleiterbauelementen aus amorphem Silizium (a-Si) zur Umwandlung von Licht in elektrische Energie unter Abscheiden des amorphen Siliziums mittels Glimmentladung aus Silan oder anderen geeigneten Si-Verbindungen in einem Abscheidungsgefäß, wobei zusätzlich ein Magnetfeld verwendet wird, und eine Einrichtung zur Durchführung des Verfahrens.

Aussichtsreich als neues, wesentlich billigeres Material gegenüber kristallinem Silizium für den genannten Zweck ist amorphes Silizium (a-Si). Für die Verwendung von a-Si spricht vor allem, daß dieses wegen der wesentlich höheren optischen Absorption nur in Schichtdicken von etwa 1 µm benötigt wird, bei kristallinem Si sind hingegen mindestens 50 bis 100 µm Materialdicke notwendig. Amorphes Silizium kann direkt aus der Gasphase auf relativ billigen Substraten abgeschieden werden, anschließend sind im Gegensatz zum kristallinen Si keine kostenträchtigen Materialbearbeitungsprozesse notwendig.

Es ist aus der DE-A-2 743 141 bekannt, zum Herstellen von Halbleiterbauelementen aus a-Si eine Glimmentladung z. B. aus Silan einzusetzen. Dazu wird eine aus Glas bestehende Vakuumglocke verwendet, in welche eine Elektrode mit gegenüberliegender Heizplatte eingeführt ist. Ein Auslaß der Glocke ist an eine Diffusionspumpe, ein weiterer an eine mechanische Pumpe und ein dritter Auslaß an ein Gaszuführungssystem angeschlossen, das als Quelle für die bei der Glimmentladung benötigten Gase dient. Das Substrat, mit dem das a-Si abgeschieden werden soll, z. B. nichtrostender Stahl, wird auf die Heizplatte gelegt. Eine Energiequelle, die gewöhnlich im HF-Bereich betrieben wird, ist mit der Elektrode und dem Substrat verbunden.

Auch aus der US-A-3 655 438 ist ein Verfahren der hier in Frage stehenden Art bekannt. Dort ist aber nicht erkannt worden, daß eine definierte Richtung zum elektrischen Feld, ausgehend vom magnetischen Feld, dazu führt, daß die Elektronenbahnen immer in sich geschlossen sind, und zwar in sich geschlossen torusförmig eine Glimmentladung herbeiführen.

Mit solchen Halbleiterbauelementen wurden bis jetzt Wirkungsgrade von einigen Prozent erreicht. Um für einen wirtschaftlichen Einsatz interessant zu sein, ist es jedoch notwendig, den Wirkungsgrad der Zellen entscheidend zu verbessern. Es ist bekannt, daß u. a. für die elektrischen Eigenschaften von a-Si der Einbau von Wasserstoff von großer Wichtigkeit ist, siehe auch W. E. Spear et al., Solid State Comm. 17, 1193, 1975. Dieser dient zur Absättigung von »dangling bonds« und führt so zu einer Verringerung der lokalisierten Zustände in der Beweglichkeitslücke. Die Anzahl dieser Zustände wiederum ist direkt verantwortlich für die Ausdehnung der Feldzone, welche sich vom p-n-Übergang oder vom Schottky-Kontakt aus in der a-Si-Zelle ausbreitet. Wenige lokalisierte Zustände bedeuten breite erreichbare Feldzone. Da bei einer a-Si-Zelle nur diejenigen elektrischen Ladungsträger zum Wirkungsgrad der Zelle beitragen, welche unmittelbar in der Raumladungszone erzeugt werden — die Diffusion von Ladungsträgern von Bereichen außerhalb der Feldzone spielt eine untergeordnete Rolle —, ist eine große Breite dieser Zone, möglichst von der Größe der gesamten a-Si-Zellendicke, also etwa 1 µm, erstrebenswert. Nur dann ist es möglich, daß auch diejenigen Ladungsträger einen Beitrag zum Wirkungsgrad leisten, die vom längerwelligen und tiefer in das a-Si eindringenden Anteil des Sonnenlichts herrühren. Bei den besten bisher bekannten a-Si-Zellen wurden Weiten der Feldzone von etwa 0,2 µm abgeschätzt.

Aufgabe der Erfindung ist es, ein Verfahren anzugeben, durch das Halbleiterbauelemente aus a-Si mit erheblich höherem Wirkungsgrad dadurch erhalten werden, daß eine Glimmentladung mit wesentlich erhöhter Gasionisation des jeweils verwendeten Gases durchführbar ist, und eine Einrichtung hierzu anzugeben.

Diese Aufgabe ist dadurch gelöst, daß das Magnetfeld transversal zum elektrischen Feld verläuft und derart beschaffen ist, daß die Elektronen aus der Gasentladung auf in sich geschlossenen Bahnen oberhalb des Substrats geführt werden.

Eine Einrichtung ergibt sich aus den Unteransprüchen.

Mit Hilfe der Erfindung ist es möglich, Feldzonen der Weite über 0,5 µm zu erzielen und dadurch Wirkungsgrade von über 6% zu erhalten. Weitere Vorteile der Erfindung sind, daß die Materialpräperation bei kleineren Abscheidetemperaturen erfolgen kann und daß höhere elektrische Leitfähigkeiten der n- oder p-dotierten Schichten erreicht wird. Durch das Magnetfeld werden im Entladungsraum die die Gasionisation bewirkenden Elektronen auf Bahnen in der Nähe der Substratoberfläche gehalten. Dies bewirkt einen starken Anstieg der Gasionisierung hauptsächlich in Substratnähe. Vor allem wird das Angebot von atomarem Wasserstoff bzw. der jeweils verwendeten Gasart, z. B. auch Halogenen stark erhöht, dessen Einbau in das a-Si für die Verringerung der Anzahl der lokalisierten Zustände in der Beweglichkeitslücke des a-Si verantwortlich ist.

Die Erfindung ist anhand der Figuren näher erläutert. Es zeigt

Fig. 1 ein Abscheidungsgefäß für die Glimmentladung,

Fig. 2, 3 Magnetfeldanordnungen.

Das Abscheidungsgefäß 1 für die Abscheidung von a-Si/H besteht im wesentlichen aus rostfreiem Stahl. Von oben und unten sind Elektroden 2 und 3 eingeführt. Diese sind mit einem HF-Sender 4 verbunden. An den Elektroden befinden sich die Substrate 5 und 6, welche z. B. aus nichtrostendem Stahl oder Glas bestehen.

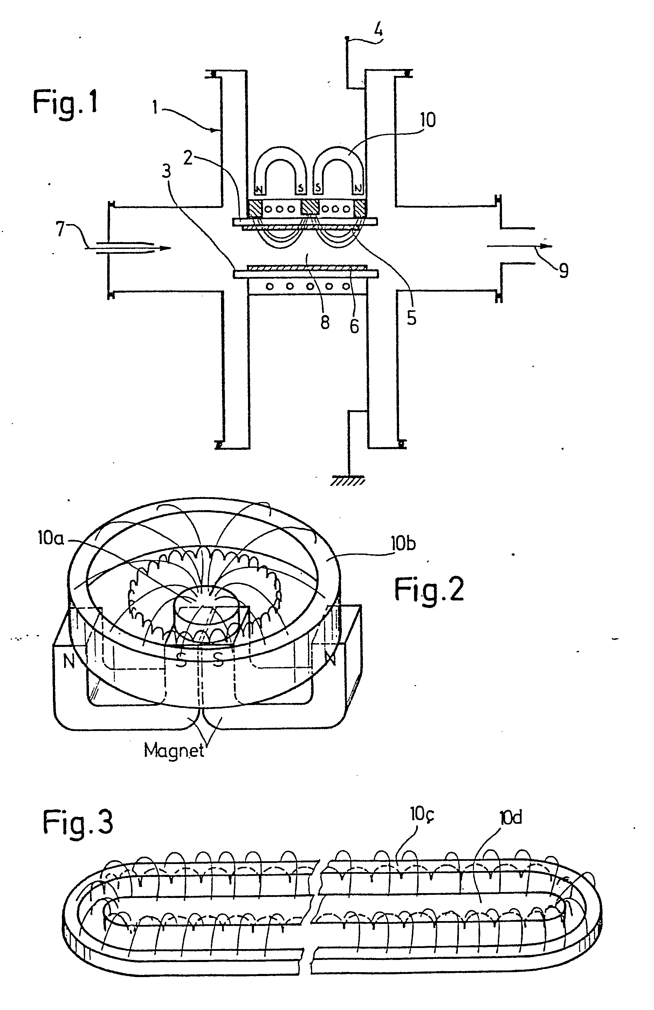

Das Reaktionsgas, ein Gemisch aus $SiH_4/H_2$ oder anderen geeigneten Gasen, wird von links her durch einen Gaseinlaß 7 in das Abscheidungsgefäß 1 geleitet und strömt zum Reaktionsraum 8, das ist das Volumen zwischen den Elektroden 2 und 3. Die nach der Reaktion übrigbleibenden Gase werden von einer Pumpe 9 abgesaugt. Die Magnetanordnung 10, die oberhalb der Elektrode 2 angebracht ist, kann — in einer anderen Ausführung — aber auch unterhalb der Elektrode 3 oder sowohl oberhalb und unterhalb von Elektrode 2 und 3 liegen, siehe auch Fig. 2, 3. Die Magnetlinien treten aus einer ringförmigen Polplatte 10a in den Reaktionsraum 8 und münden wieder in eine kreisförmige Polplatte 10b im Zentrum der Anordnung ein. Das Magnetfeld ist bezüglich der eingezeichneten Achse symmetrisch und bildet — von oben betrachtet — einen kreisförmigen Ring. Die Polplatten 10a, 10b, welche aus magnetischen Materialien, z. B. Eisen, bestehen, werden von den darunter befindlichen u-förmigen Magneten gespeist. In der Fig. 3 wird die Anordnung wesentlich gestreckt. Die Polplatten 10c und 10d werden hier von einer größeren Anzahl von Magneten gespeist, und es entsteht ein beliebig langer, gestreckter magnetischer Ring. Auf diese Weise kann das gewünschte Magnetfeld für sehr viel größerere Elektroden, welche großflächig mit Substraten belegt sind, erzeugt werden. Magnetfelder der in Fig. 2, 3 gezeigten Art können natürlich auch mit Hilfe von Elektromagneten erzeugt werden. Weiterhin sind noch andere Magnetfeldkonfigurationen denkbar. In jedem Fall ist aber wichtig, daß über einen möglichst großen Bereich das erzeugte Magnetfeld transversal zum elektrischen Feld verläuft.

In beiden Anordnungen werden, wenn der HF-Sender 4 in Betrieb ist, und das Gasgemisch durch das Abscheidungsgefäß 1 strömt, durch die kombinierte Einwirkung von elektrischem und magnetischem Feld Elektronen aus der Gasentladung auf Zykloidenbahnen oberhalb der Substratoberfläche geführt. Gegenüber einer Entladung ohne Magnetfeld wird die Verweilzeit der Elektronen im Reaktionsraum 8 bedeutend gesteigert, und es kommt zu der wesentlichen Erhöhung der Gasionisation.

Die Elektronen laufen auf den Zykloidenbahnen entlang des magnetischen Ringes und sind in sich geschlossen. Der Radius der Zykloidenbögen wird von der Größe der elektrischen und magnetischen Feldstärke $\vec{E}$ und $\vec{H}$ bestimmt und wird so gewählt, daß die Weite der Bögen kleiner bleibt als der Abstand der Elektroden 2 und 3 voneinander, so daß kein Elektronenverlust durch Stöße mit den Elektroden stattfinden kann. Nur dann können die Elektronen den magnetischen Ring immer wieder durchlaufen, und es kann die hohe Gasionisierung permanent aufrechterhalten werden. Typische erforderliche

Werte für $\vec{E}$ bzw. $\vec{H}$ sind 400 bis 800 V/cm bzw. 100 bis 300 Gauß. Da die beschriebene Anordnung mit Wechselstrom hoher Frequenz, z. B. 13,56 MHz betrieben wird, ist für $\vec{E}$ ein Mittelwert des elektrischen Potentials, welches an der Elektrode 2 entsteht, maßgebend.

## Patentansprüche

1. Verfahren zur Herstellung von Halbleiterbauelementen aus amorphem Silizium zur Umwandlung von Licht in elektrische Energie unter Abscheiden des amorphen Siliziums mittels Glimmentladung aus Silan oder anderen geeigneten Si-Verbindungen in einem Abscheidungsgefäß, wobei zusätzlich ein Magnetfeld verwendet wird, dadurch gekennzeichnet, daß das Magnetfeld transversal zum elektrischen Feld verläuft und derart beschaffen ist, daß die Elektronen aus der Gasentladung auf in sich geschlossenen Bahnen oberhalb des Substrats (5, 6) geführt werden.

2. Verfahren nach Anspruch 1, dadurch gekennzeichnet, daß der Radius der Bahnen in Abhängigkeit von der elektrischen Feldstärke (E) und der magnetischen Feldstärke (H) so gewählt wird, daß die Weite der Bögen kleiner bleibt als der Abstand der der Glimmentladung dienenden Elektroden (2, 3).

3. Einrichtung zur Durchführung des Verfahrens nach Anspruch 1 und/oder Anspruch 2, mit einem Abscheidungsgefäß, darin eingeführten, mit einem HF-Sender verbundenen Elektroden, auf denen das Substrat angeordnet ist, Gasein- und -auslaß, dadurch gekennzeichnet, daß eine Magnetanordnung (10) hinter gegenüberliegenden oberen oder unteren Elektroden (2, 3) oder hinter beiden Elektroden (2, 3) angebracht ist und daß die Magnetanordnung (10) Polplatten aufweist, wobei eine Polplatte (10a) nach Art eines Kreisringes oder auch gestreckten Kreisringes (10c) ausgebildet ist und die andere Polplatte (10b, 10d) im Zentrum der ersten Polplatte (10a, 10c) angeordnet ist.

## Claims

1. A method of producing semi-conductor componente from amorphous silicon for converting light into electrical energy along with precipitation of the amorphous silicon by means of glow discharge from silane or other suitable Si-compounds in a precipitation vessel, in which additionally a magnetic field is used, characterised in that the magnetic field extends transversely to the electrical field and is of such a nature that the electrons from the gas discharge are conducted on closed paths above the substrate (5, 6).

2. A method according to claim 1, characterised in that the radius of the paths is so selected as a function of the electrical field intensity (E) and of the magnetic field intensity that the width of the arcs remains smaller than the spacing of the electrodes (2, 3) serving for the glow discharge.

3. Apparatus for carrying out the method according to claim 1 and/or claim 2, with a precipitation vessel, electrodes which are introduced therein and which are connected to an HF transmitter and on which the substrate is arranged, a gas inlet and outlet, characterised in that a magnet arrangement (10) is installed behind opposite upper or lower electrodes (2, 3) or behind both electrodes (2, 3), and in that the magnet arrangement has pole plates, in which one pole plate (10a) is designed in the manner of an annulus or even as elongate annulus (10c) and the other pole plate (10b, 10d) is arranged in the middle of the first pole plate (10a, 10c).

**Revendications**

1. Procédé de fabrication de composants semiconducteurs en silicium amorphe pour convertir de la lumière en énergie électrique, par dépôt de silicium amorphe par décharge électrique lumineuse à partir de silane ou autres composés de silicium appropriés dans un appareil de dépôt, en utilisant en plus un champ magnétique, caractérisé en ce que le champ magnétique est dirigé transversalement par rapport au champ électrique et est produit de manière que les électrons de la décharge dans le gaz soient guidés au-dessus du substrat (5, 6) dans des trajectoires fermées.

2. Procédé selon la revendication 1, caractérisé en ce que le rayon des trajectoires est choisi en fonction de l'intensité (E) du champ électrique et l'intensité (H) du champ magnétique de manière que la largeur de l'arc reste inférieure à la distance des électrodes (2, 3) servant à la décharge électrique.

3. Dispositif pour la mise en oeuvre du procédé selon la revendication 1 et/ou la revendication 2, avec un appareil de dépôt dans lequel sont introduites des électrodes connectées à un émetteur HF, sur lesquelles le substrat est disposé, et une entrée et une sortie de gaz, caractérisé en ce qu'un dispositif magnétique (10) est monté derrière les électrodes supérieure ou inférieure (2, 3) se faisant face ou derrière les deux électrodes (2, 3), et que le dispositif magnétique comporte des plaques polaires (10), une plaque polaire (10a) étant réalisée sous la forme d'un anneau circulaire ou même d'un anneau circulaire allongé (10c) et l'autre plaque polaire (10b, 10d) étant disposée au centre de la première plaque polaire (10a, 10c).

Fig.1

Fig.2

Magnet

Fig.3

5